# EUROPEAN PATENT APPLICATION

(11) **EP 1 811 530 A2**
(43) Date of publication of application: **25.07.2007**
(21) Application number: 07100991.4
(22) Date of filing: 23.01.2007
(51) Int. Cl.: H01F 17/00, H02M 3/335, H01F 27/36

(54) **Inductor apparatus**

(30) Priority: 24.01.2006 CN 200610002220
(71) Applicant: ASUSTeK Computer Inc., Peitou, Taipei (TW)
(72) Inventor: Huang, Sheng-Chung, Taipei (TW); Liang, Ching-Ji, Taipei (TW)
(74) Representative: Viering, Jentschura & Partner

(57) **Abstract**

The present invention provides a multi-layer inductor structure. A metal film is used to form the coils. The dielectric material of the inductor in the present invention is air or the printed circuit board. The metal film surrounding a point is formed in a multi-layer printed circuit board. The multi-layer inductor structure occupies a smaller area in the motherboard but has the same inductance compared with a single layer inductor structure.

## Description

### Related Applications

The present application is based on, and claims priority from, China Application Serial Number 200610002220.3, filed January 24, 2006, the disclosure of which is hereby incorporated by reference herein in its entirety.

### Field of the Invention

The present invention is related to an inductor apparatus, and more particularly to an inductor apparatus used in a motherboard.

### Background of the Invention

Many electrical devices with different operation voltages are installed on motherboards. To match the different operation voltages of the electrical devices, many DC/DC converters are required to switch different voltages.

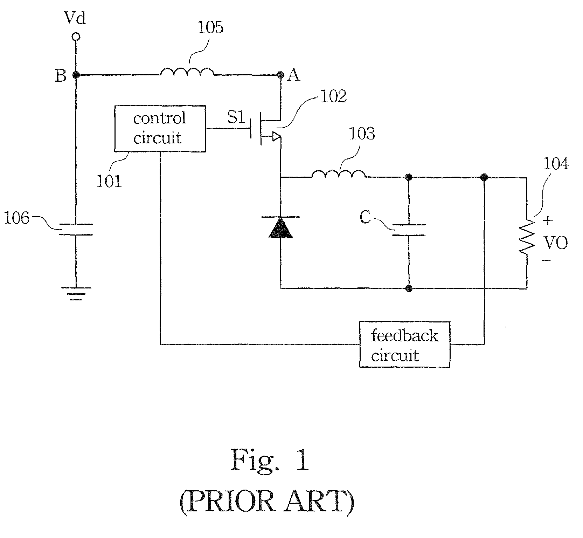

Figure 1 illustrates a schematic diagram of a buck type DC/DC converter. A control circuit 101 is used to control the on/off period of the transistor 102 to control the output voltage. When the transistor 102 is in an on state, a current flows through the inductor 103. Energy is saved in the inductor 103. When the transistor 102 is in an off state, the energy saved in the inductor 103 is released to a load 104 to maintain the output voltage. Moreover, to prevent noise generated by the transistor 102 switch from influencing the electrical device installed on the motherboard, a filter that consists of an inductor 105 and a capacitor 106 is added on the input end of the buck type DC/DC converter to filter noise.

Typically, the inductor 105 is composed of coils and a core. The coils surround the core. The inductors 105 are manually arranged and installed at predetermined locations on the motherboard. The labor cost of using people in the foregoing process is high. Therefore, an improved inductor structure is desired.

### Summary of the Invention

The main purpose of the present invention is to provide an inductor structure that may be directly formed in the motherboard to reduce labor costs.

Another purpose of the present invention is to provide an Inductor structure without a core.

A further purpose of the present invention is to provide a planar inductor structure to reduce the thickness of the printed circuit board.

According to the foregoing purposes, the present invention provides an inductor structure. A metal film is used to form the coils. The dielectric material of the inductor in the present invention is air or the printed circuit board. The metal film surrounding a point is formed in the printed circuit board In an embodiment, the present invention provides a multi-layer inductor structure. A metal film is used to form the coils. The dielectric material of the inductor in the present invention is air or the printed circuit board. The metal film surrounding a point is formed in a multi-layer printed circuit board. The multi-layer inductor structure occupies a smaller area in the motherboard but has the same inductance compared with a single layer inductor structure. Therefore, the motherboard volume may be reduced.

In an embodiment, the present invention provides an inductor structure. This inductor is used in an input end of a buck type DC/DC converter to avoid noise generated by the transistor switch to influence the other devices over the motherboard. A metal film is used to form the coils of the inductor. The dielectric material of the inductor is air or the printed circuit board. The metal film surrounding a point is formed in a printed circuit board.

### Brief Description of the Drawings

The foregoing aspects and many of the attendant advantages of this invention are more readily appreciated and better understood by referencing the following detailed description, when taken in conjunction with the accompanying drawings, wherein:
Figure 1 illustrates a schematic diagram of a Buck type DC/DC converter;
Figure 2A and figure 2B illustrate a schematic diagram of an inductor apparatus according to a preferred embodiment of the present invention;
Figure 3A illustrates a signal waveform that is not filtered by a capacitor and an inductor;
Figure 3B illustrates a signal waveform that is filtered by a capacitor and an inductor; and
Figure 3C illustrates a signal waveform that is filtered by a capacitor and an inductor according to the present invention.

### Detailed Description of the Preferred Embodiment

The inductor apparatus of the present invention includes coils made, for example, with a copper film. The dielectric material of the inductor apparatus is air or the printed circuit board. The metal film is twisted into a spiral to form in the printed circuit board. The inductance of the inductor is related to the number of circles in the metal film spiral. In other words, the inductance of an inductor is raised by increasing the number of circles in the metal film spiral. There are two methods to increase the number of circles in the metal film spiral. One method is to increase the number of circles in the metal film spiral in a single layer printed circuit board. Such a method increases the area occupied by the inductor. The other method is to respectively form the metal film spiral in different layers of a multi-layer printed circuit board. Vias are then used to connect with these spiraled metal films. Such laminated construction will increase the number of circles in the metal film spiral without increasing the area occupied by the inductor. Therefore, reducing the size of the printed circuit board.

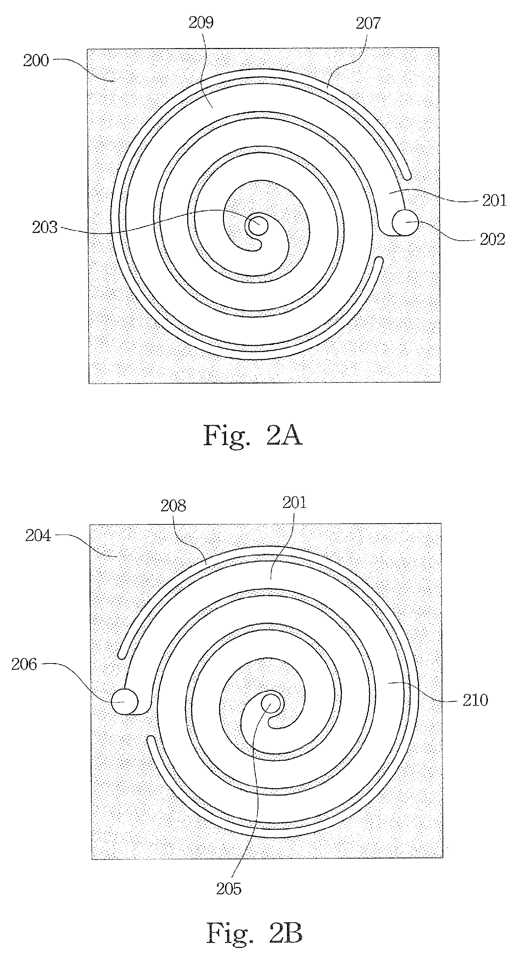

An example of metal film spirals formed in different layers of a multi-layer printed circuit board is described in detail in the following explanation of the application of the present invention. A top layer, a power layer, a grounded layer and a signal layer together compose a four-layer printed circuit board structure. The communication among these layers is through vias. The printed circuit board, for example, is a motherboard or a VCD card. In an embodiment of the present invention, the spiraled metal films 201 are formed in the top layer 200 and the power layer 204 to form a first coil 209 and a second coil 210 respectively as shown in figure 2A and figure 2B.

In figure 2A, the first coil 209 formed in the top layer 200 is spiraled anti-clockwise from a first point 202 to the second point 203. The first point 202 is a pin for connecting with another circuit. In this embodiment, the first point 202 corresponds to the B point in figure 1. The second point 203 is a center point of the first coil 209.

In figure 2B, the second coil 210 formed in the power layer 204 is spiraled anti-clockwise from a third point 205 to the fourth point 206. The fourth point 206 is a pin for connecting with another circuit. In this embodiment, the fourth point 206 corresponds to the A point in figure 1. The third point 205 is a center point of the second coil 210.

The first coil 209 located in the top layer and the second coil 210 located in the power layer communicate with each other through a via. In other words, the second point 203 of the first coil 209 is connected with the third point 205 of the second coil 210 through a via. In this embodiment, both the first coil and the second coil are spiraled anti-clockwise. Therefore, the direction of the magnetic field generated by the first coil 209 and the second coil 210 is the same. Moreover, for preventing the magnetic field generated by the first coil 209 and the second coil 210 to influence other electrical devices, two grounded rings 207 and 208 are formed around the first coil 209 and the second coil 210 respectively.

It is noticed that the current is related to the width of the metal film 201. Therefore, the width of the metal film 201 may be designed based on the required current. Moreover, other surrounded shapes, such as a square or an ellipse, may be used in the present invention. On the other hand, the spiraled metal films may be formed in many layers based on inductance requirements. For example, an additional via may be formed in the fourth point 206 for connecting the second coil 210 to the other coil to increase the inductance. A typical inductor and the spiraled metal films may be connected together to reach the required inductance.

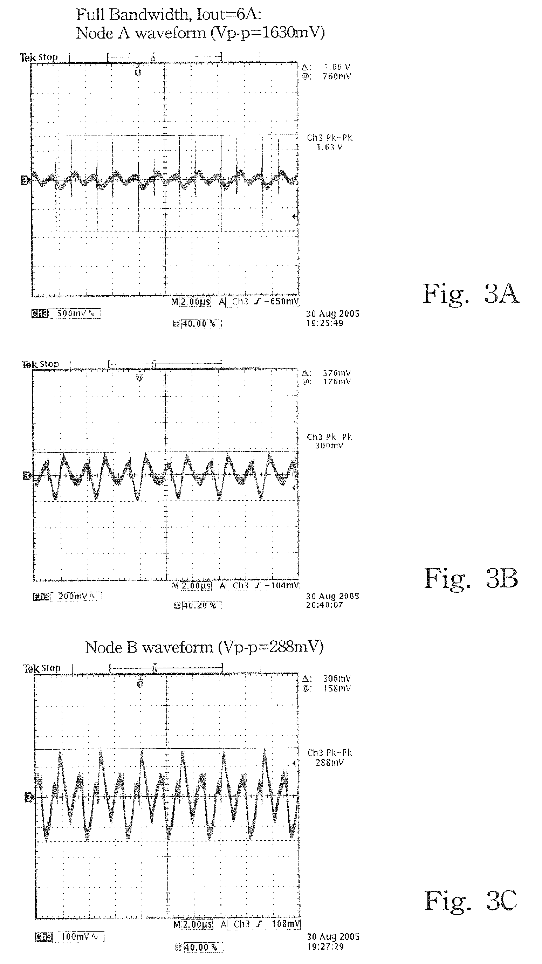

Figure 3A illustrates a signal waveform of node A in figure 1. In figure 3A the signal is not filtered by a capacitor 106 or an inductor 105. Please refer to figure 1 and figure 3A. As shown in figure 3A, large amounts of noise exist in the signal. The noise is caused by the switch in the transistor 102. The peak to peak voltage is 1.67V. Figure 3B illustrates a signal waveform of node B in figure 1. In this figure, the signal is filtered by a capacitor 106 and an inductor 105. As shown in the figure 3B, noise has been filtered. Therefore, the peak to peak voltage is 360mV. Figure 3C illustrates a signal waveform of node B in figure 1. In this figure, the signal is filtered by a capacitor and an inductor apparatus of the present invention. As shown in figure 3C, noise has been filtered. The peak to peak voltage is only 288mV. Obviously, the filter efficiency of the inductor apparatus of the present invention is the same as the typical inductor apparatus.

Accordingly, to resolve the high cost of typical inductor apparatus, a melt film is used in the inductor apparatus of the present invention. The spiraled metal film is used to form the coils and is directly formed in the printed circuit board. The dielectric material of the inductor is air or the printed circuit board. No core is used in the present invention, which may reduce the cost. Moreover, the spiraled metal film is directly formed in the printed circuit board, which saves manual labor. On the other hand, the spiraled metal film may be formed in different layers of a multi-layer printed circuit board. The multi-layer inductor structure occupies a smaller area on the motherboard but has the same inductance compared with a single layer inductor structure. Therefore, the motherboard volume may be reduced.

As is understood by a person skilled in the art, the foregoing descriptions of the preferred embodiment of the present invention are an illustration of the present invention rather than a limitation thereof. Various modifications and similar arrangements are included within the spirit and scope of the appended claims. The scope of the claims should be accorded to the broadest interpretation so as to encompass all such modifications and similar structures. While preferred embodiments of the invention have been illustrated and described, it will be appreciated that various changes can be made therein without departing from the spirit and scope of the invention.

## Claims

1. An inductor apparatus located on the input end of a DC/DC converter, wherein said DC/DC converter comprises a transistor, said inductor apparatus comprising:
a metal film located in a printed circuit board with a first connection point and a second connection point, wherein said metal film is spiraled from and around said second connection point, said second connection point couples with said transistor, said first connection point couples with a capacitor to form a filter to filter noise from said transistor switch.

2. The inductor apparatus of claim 1, further comprises a grounded ring around said melt film to prevent an expansion of the magnetic field generated by said inductor apparatus.

3. The inductor apparatus of claim 1, wherein when said DC/DC converter is a Buck-type DC/DC converter

4. The inductor apparatus of claim 1, wherein said melt film is a copper film.

5. The inductor apparatus of claim 1, wherein a dielectric material of said inductor apparatus is air.

6. An inductor apparatus, wherein the said inductor apparatus is located on the input end of a DC/DC converter that is formed in a multi-layer printed circuit board to isolate switch noise generated by said DC/DC converter, comprising:
a plurality of metal film located in different layers of said multi-layer printed circuit board respectively, wherein each of said melt films has a first connection point and a second connection point, and each of said metal films is spiraled from and around said second connection point, two melt films respectively located in adjacent layers are connected together through a via, and the first connection point of the melt film located in a top layer of said multi-layer printed circuit board couples with a capacitor to form a filter to filter said switch noise.

7. The inductor apparatus of claim 6, further comprising a plurality of grounded rings around said melt films respectively to prevent the expansion of a magnetic field generated by said inductor apparatus.

8. The inductor apparatus of claim 6, wherein when said DC/DC converter is a Buck-type DC/DC converter

9. The inductor apparatus of claim 6, wherein said melt films are copper films.

10. The inductor apparatus of claim 6, wherein a dielectric material of said inductor apparatus is air.
